(19) Europäisches Patentamt
European Patent Office
Office européen des brevets

(11) **EP 4 318 928 A1**

(12) **EUROPEAN PATENT APPLICATION**

(43) Date of publication:
**07.02.2024 Bulletin 2024/06**

(21) Application number: **22188376.2**

(22) Date of filing: **02.08.2022**

(51) International Patent Classification (IPC):
**H02N 11/00** (2006.01)   **H10N 15/00** (2023.01)

(52) Cooperative Patent Classification (CPC):
**H02N 11/002; H10N 15/00**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Max-Planck-Gesellschaft zur Förderung der Wissenschaften e.V.**
**80539 München (DE)**

(72) Inventor: **MANNHART, Jochen**
**71032 Böblingen (DE)**

(74) Representative: **Lambsdorff & Lange Patentanwälte Partnerschaft mbB Grillparzerstraße 12A 81675 München (DE)**

(54) **USE OF DISSIPATIONLESS MACROSCOPIC CURRENTS FOR THE CONVERSION OF HEAT INTO ELECTRIC POWER**

(57) A quantum device (10; 20; 30; 40; 50) comprises a transmission structure (1; 1a, 1b; 21; 31; 41; 51) provided by a topological material (10A; 20A; 30A; 40A; 50A) and at least two terminals (5; 8; 24; 34; 42; 43; 52; 53) connected with the transmission structure; wherein the transmission structure is functional to generate currents of electrons, holes or other quasi-particles between the at least two terminals; and wherein

at least one or more of
- a region (A, B) of the topological material (40A, 50A),
- one or both of the at least two terminals (5; 8), or
- a further element or material (23; 33)

are functional to inelastically scatter at least a part of the currents.

Fig. 16

EP 4 318 928 A1

**Description**

TECHNICAL FIELD

The present disclosure describes devices and a method to convert thermal energy into electric voltages, currents, magnetic fields or inhomogeneities of temperatures or electron spin populations. In particular, the devices utilize the combination of electrically conducting channels that carry dissipationless macroscopic electric currents with incoherent electron transport characterized by non-unitary, dissipative charge transport.

BACKGROUND

In the following description reference will be made to the following documents:

> [Mannhart, 2018a] J. Mannhart, Journal of Superconductivity and Novel Magnetism 31, 1649 (2018)
> [Mannhart, 2018b] J. Mannhart and D. Braak, Journal of Superconductivity and Novel Magnetism 31, 1649 (2018)
> [Bredol, 2021] P. Bredol et al., Phys. Rev. B. 104. 115413 (2021)
> [Mannhart, 2019] J. Mannhart et al., Physica E 109, 198-200 (2019)
> [Mannhart, 2020] J. Mannhart, Journal of Superconductivity and Novel Magnetism 33, 249 (2020)
> [Mannhart, 2021] J. Mannhart, H. Boschker, and P. Bredol, Nano Express 2, 014998 (2021)
> [Gerhardts, 2008] R.R. Gerhardts, Phys. Stat. Sol. (B) 245, 378 (2008)
> [Gerhardts, 2009] R.R. Gerhardts et al., 'Quantum Hall Effect' pp 572 in Compendium of Quantum Physics, ed.: D. Greenberger et al. Springer (2009).
> [Panos, 2014] K. Panos et al., New J. Phys. 16, 113071 (2014)
> [v. Klitzing, 2005a] K. v. Klitzing, Phil. Trans. R. Soc. A 363, 2203 (2005)
> [v. Klitzing, 2005b] K. v. Klitzing et al., Phys. Journ. 4, 37 (2005)
> [v. Klitzing, 2017] K. v. Klitzing, Annu. Rev. Condens. Matter Phys. 8, 13 (2017)
> [Weis, 2011] J. Weis et al., Phil. Trans. R. Soc. A 369, 3954 (2011)
> [Oh, 2013] S. Oh, Science 340, 153 (2013).
> [Ando, 2013] Y. Ando, J. Phys. Soc. Jpn. 82, 102001 (2013)
> [Büttiker, 1988] M. Büttiker, Phys. Rev. B. 38, 9375 (1988)
> [Kane, 2011] C. Kane et al., Physics World, Feb. 2011, pp. 32

In the publications [Mannhart, 2018a,b; 2019; 2020; 2021; Bredol, 2021] and in the Patent Applications

[PCT/EP2019/052634]
[PCT/EP2019/058649]
[PCT/EP2019/074347]
[PCT/EP2020/068812]

nano-scale devices are disclosed that by means of non-reciprocal transmission of electron quantum wave packets and by inelastic scattering processes convert heat into a difference of the electrochemical potentials of two contacts of the nanodevice. Many applications require devices of macroscopic size with a length scale of mm or larger. In the patent disclosure [EP Application No. 21 209 862.8, not yet published at the filing date of the present Application] means are revealed to fabricate such macroscopic devices by appropriately assembling large numbers of the nanodevices. Fabricating macroscopic devices by these means may be complex and costly, because the nanodevices need first be patterned with a resolution comparable to the Fermi wavelength, and then be connected with the correct polarity throughout the assembly.

SUMMARY

In accordance with a first aspect of the present disclosure a quantum device comprises a transmission structure comprising a topological material and at least two terminals connected with the transmission structure; wherein

the transmission structure is functional to generate by its topological nature currents of electrons, holes or other quasi-particles between the at least two terminals; and at least one or more of

- a region of the topological material,
- one or both of the two terminals, or
- a further material

are functional to inelastically scatter at least a part of the currents.

In accordance with a second aspect of the present disclosure an array of two or more quantum devices according to the first aspect is provided, wherein the quantum devices are connected to each other in series and/or in parallel or antiparallel.

In accordance with a third aspect the present disclosure is directed to use of a quantum device according to the first aspect or an array of two or more quantum devices according to the second aspect in an electrical device by connecting the two terminal of the quantum device or the two outer terminals of the array of quantum devices with the electrical device.

In accordance with a fourth aspect of the present disclosure a method for converting thermal energy into one or more of electric voltages, currents, magnetic fields or inhomogeneities of temperatures or electron spin populations is provided, the method comprising fabricating a quantum device according to the first aspect or an array of quantum devices according to the second aspect, and connecting the quantum device to a load or other device configured to yield one or more of electric voltages, currents, magnetic fields or inhomogeneities of temperatures or electron spin populations.

The person skilled in the art recognizes additional features and advantages upon reading the following detailed description and upon giving consideration to the accompanying drawings.

DESCRIPTION OF THE DRAWINGS

The accompanying drawings are included to provide a further understanding of examples and are incorporated in and constitute a part of this specification. The drawings illustrate examples and serve together with the description to explain principles of examples. The elements of the drawings are not necessarily to scale relative to each other. Like reference numerals in the drawings designate corresponding similar parts. Other examples and many of the intended advantages of examples will be readily appreciated as they become better understood by reference to the following detailed description.

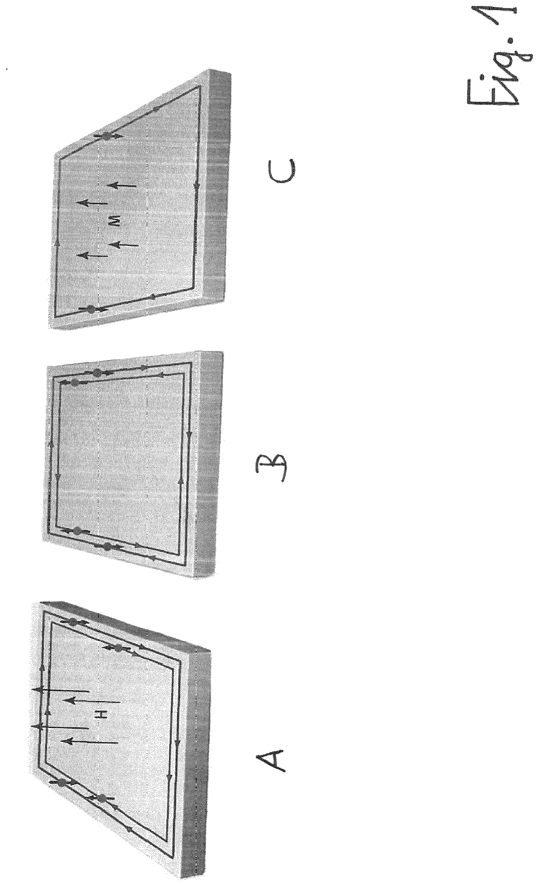

Fig. 1 comprises Figs. 1A, 1B and 1C and shows an illustration of macroscopic dissipationless currents flowing along the edges of a QHE sample (A), of a Quantum spin Hall effect sample (2D topological insulator) (B), and of a Quantum anomalous Hall effect sample (C). This Figure is taken from [Oh, 2013].

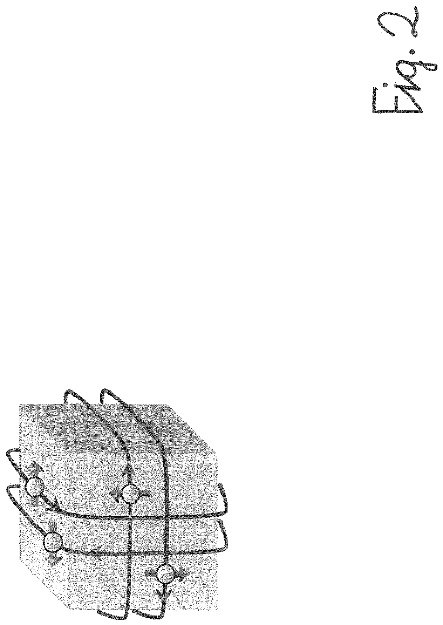

Fig. 2 shows an illustration of macroscopic dissipationless currents flowing along the surface of a 3D topological insulator. This figure is taken from [Ando, 2013].

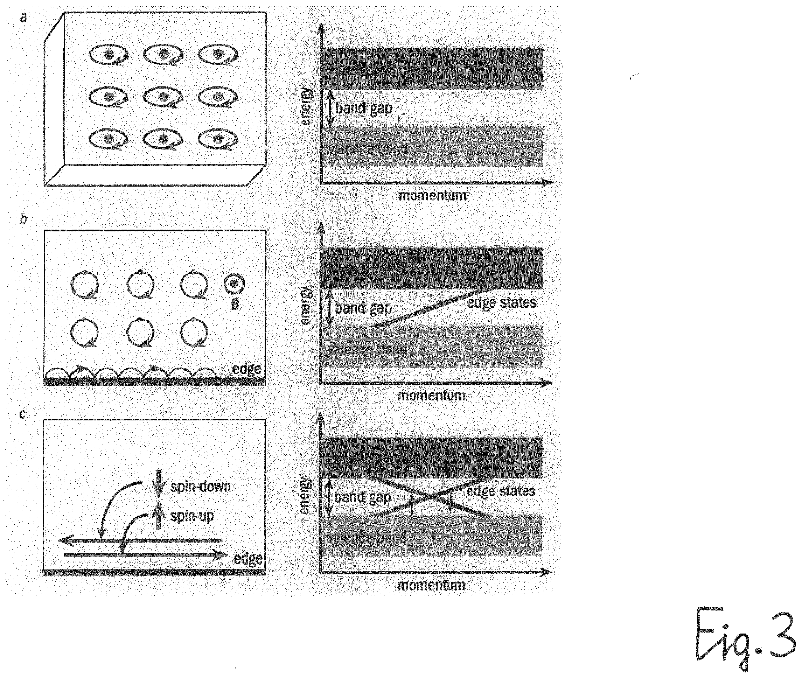

Fig. 3 comprises Figs. 3a, 3b and 3c and shows sketches showing in real space electron trajectories (left) and the corresponding band diagrams of (a) a standard semiconductor, (b) a QHE sample, and (c) a 2D topological insulator subject to a magnetic field normal to the plane of view. Panel (b) (left) sketches the Landau cylinders formed in the QHE and the at the bottom edge the purported skipping edge electron trajectory as proposed in [Büttiker, 1988]. Panel (c) shows the edge currents and bands for the up and down directions of the electrons' spins. This figure is taken from [Kane, 2011].

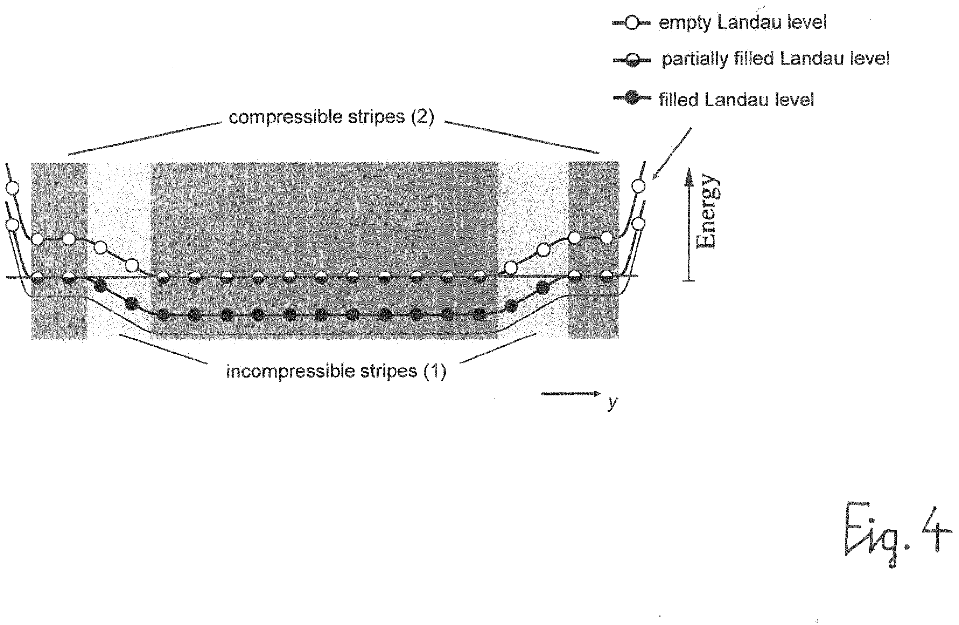

Fig. 4 shows an illustration of the energy and filling of the Landau levels in a QHE sample. The energy of the Landau levels increase towards the two edges of the sample, causing the formation of incompressible (1) and compressible stripes (2). This figure is taken from [Panos, 2014].

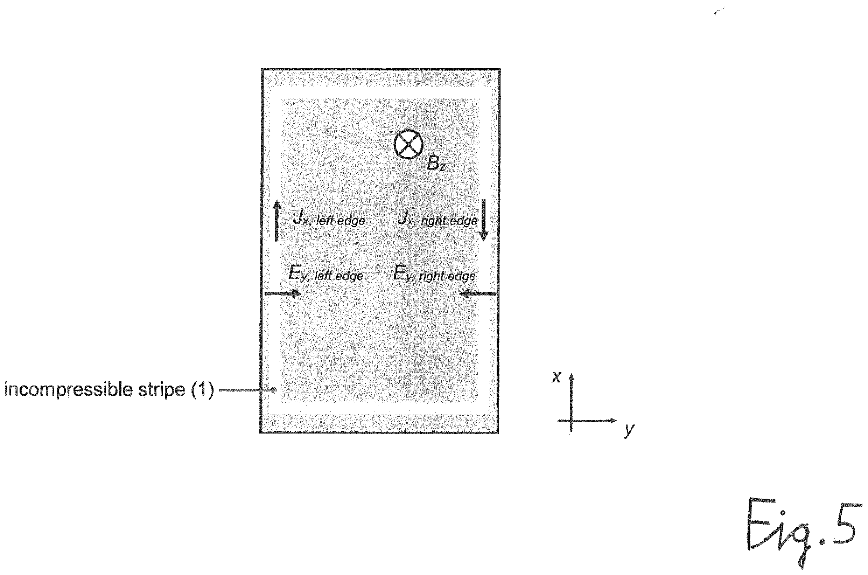

Fig. 5 shows an illustration of the top view of a QHE sample subject to a magnetic field $B_z$. An incompressible stripe (1) forms a closed loop along the sample edges. This loop carries a dissipationless current that circles the loop with a linear density $J_x$. The current is a drift current induced by the electric field $E_y$.

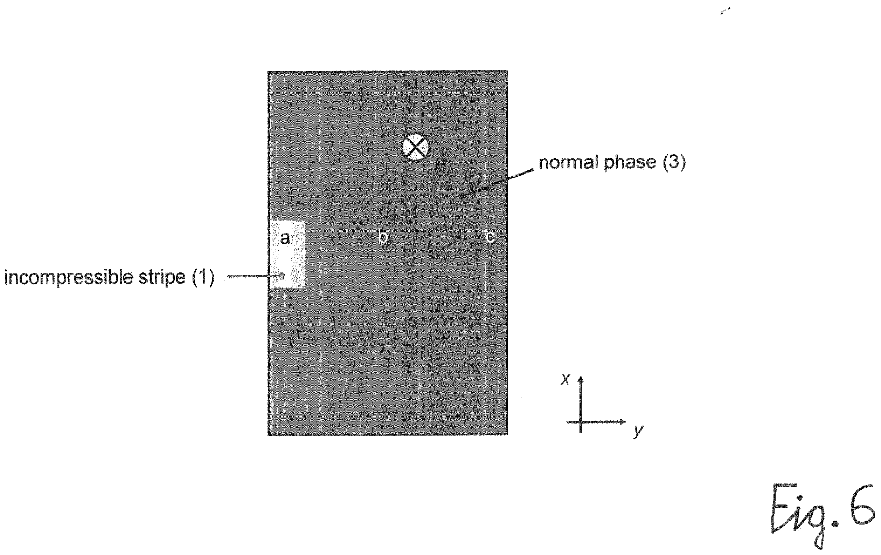

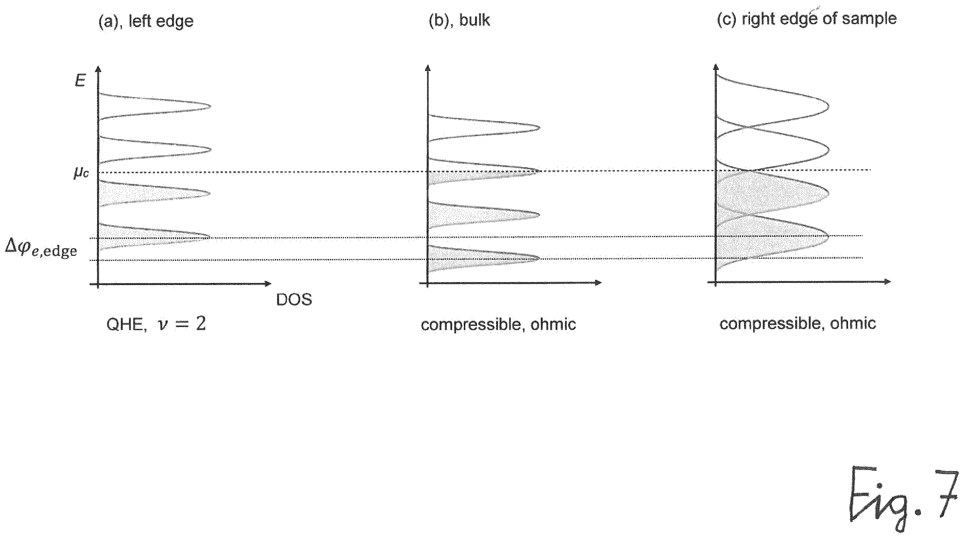

Fig. 6 shows an illustration of the top view of a QHE sample subject to a magnetic field $B_z$. A part of the sample has been modified to reduce the electronic mean free path to $l_e \ll r_c$ (normal phase (3)). Therefore, an incompressible stripe (1) is only formed in the remaining part of the sample with a mean free path of $l_e \gg r_c$ yielding the QHE. The labels $a,b,c$ indicate the positions at which the energy diagrams shown in Fig. 7 are taken.

Fig. 7 shows an illustration of the Landau levels at the left, center and right part of the sample (positions a,b,c, respectively) shown in Fig. 6. An incompressible stripe is formed only at the left sample edge (Landau levels either completely full or empty). The Landau levels at the right edge are broadened and overlap due to $l_e \ll r_c$. Therefore, at the right edge, the electron system is not fully gapped. As a result, incompressible stripes can not be generated at this sample edge, causing an ohmic behavior for charge transport.

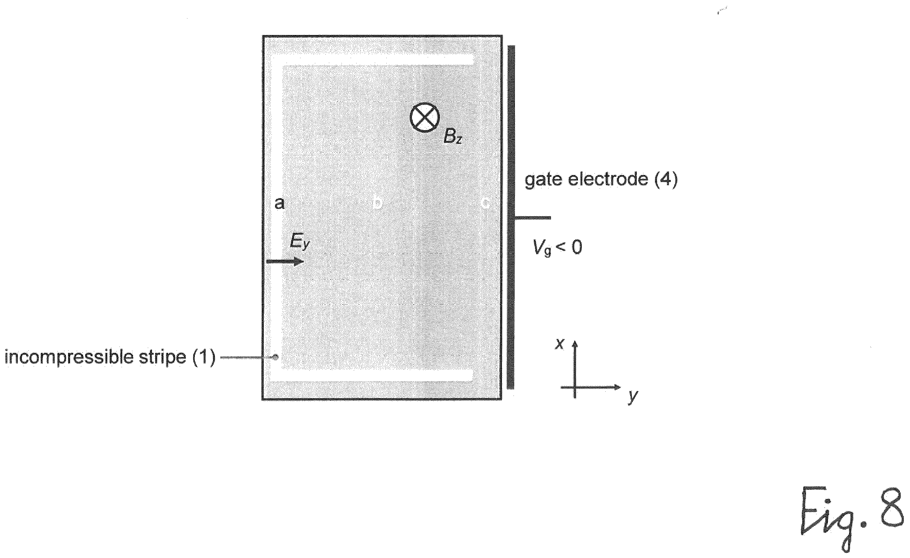

Fig. 8 shows an illustration of the top view of a QHE sample subject to a magnetic field $B_z$. An incompressible stripe (1) is formed at parts of the sample edge. At other parts, an electric field induced by the gate electrode (4) , here placed at the sample's side, alters the electric field $E_y$ such that the formation of an incompressible stripe is suppressed at the respective part of the sample edge. For the example given, the gate voltage is negative with respect to the sample. The labels $a,b,c$ indicate the positions at which the energy diagrams shown in Fig. 7 are taken.

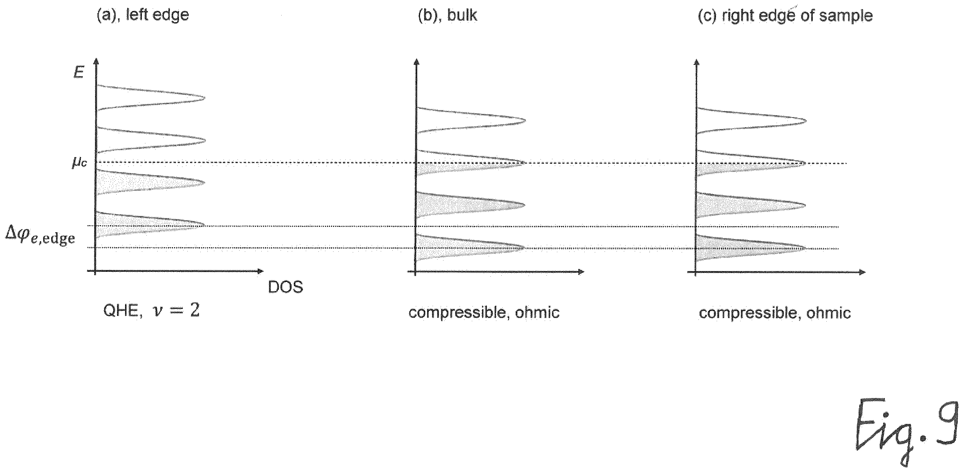

Fig. 9 shows an Illustration of the Landau levels at the left, center and right part of the sample (positions a,b,c, respectively) shown in Fig. 8. An incompressible stripe is formed only at the left sample edge (Landau levels either completely full or empty). At the right sample edge the electrochemical potential stays with a Landau level. As a result, band bending is suppressed at the right sample edge, incompressible stripes cannot be generated at this edge, and charge transport is ohmic.

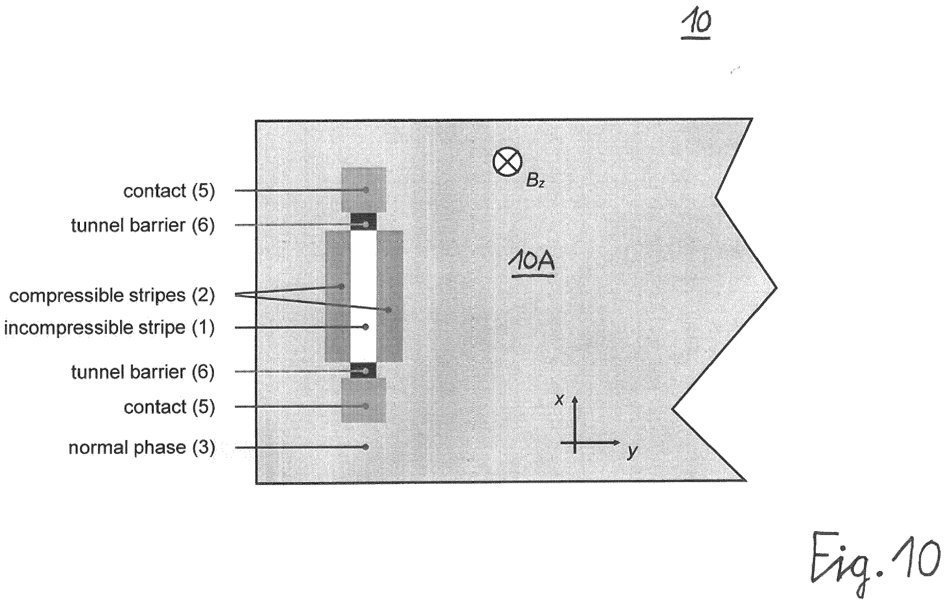

Fig. 10 shows an illustration of the top view of part of a QHE sample subject to a magnetic field $B_z$. As illustrated by the example of Fig. 6, part of the sample is in the ohmic phase such that the incompressible 1 and compressible 2 are straight stripes, and are not closed into loops. Two contacts 5 are connected to the two stripes via tunnel barriers 6. Such an arrangement we denote as 'stripe-element'. The two contacts 5 may connect to the normal phase 3 or to at least one other stripe-element.

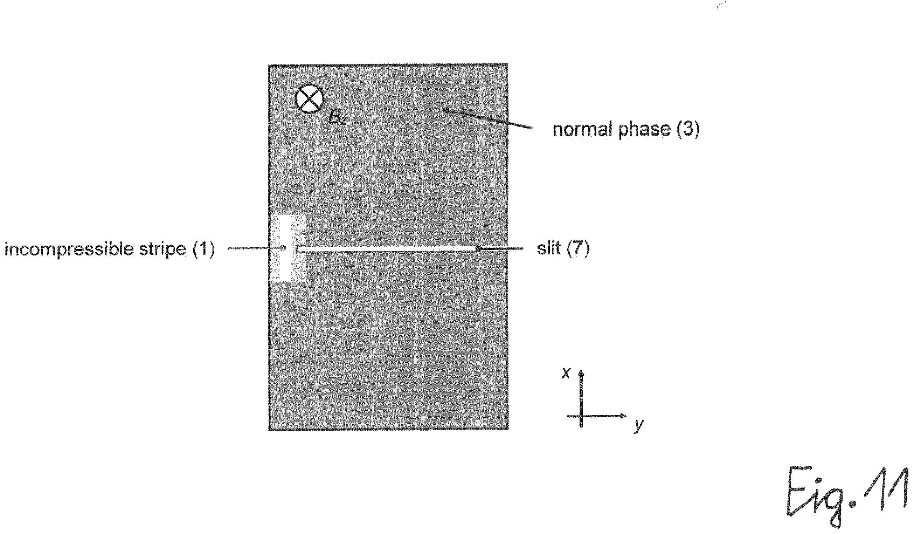

Fig. 11 shows an illustration of the top view of a QHE sample subject to a magnetic field $B_z$ according to Fig. 6. The 2D electron system of the sample has been locally removed by cutting the slit 7 into the sample.

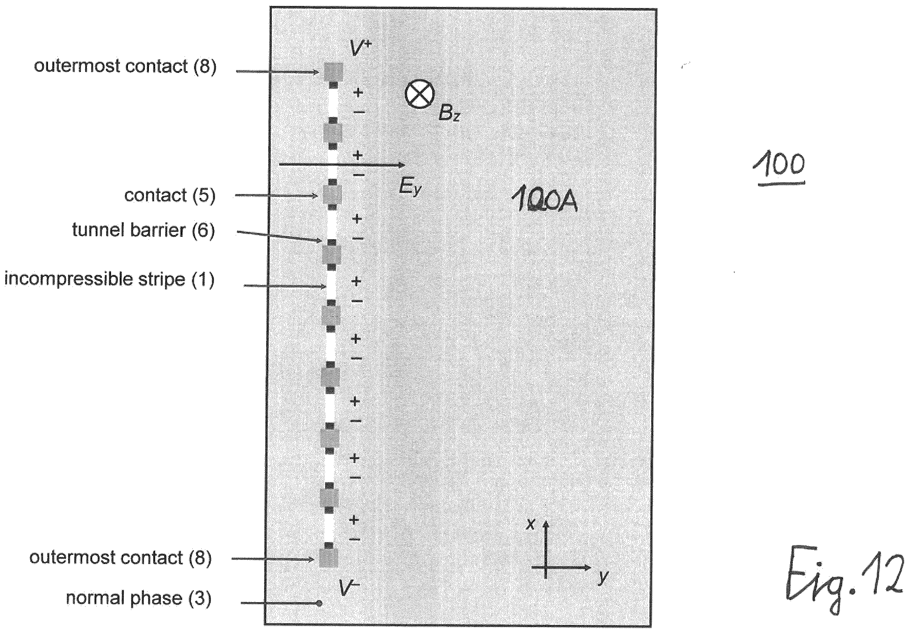

Fig. 12 shows an example of an array according to the second aspect, in particular a top view of a QHE sample subject to a magnetic field $B_z$ chosen such that the main part of the sample contains a compressible electron fluid. The sample shows a series connection of contacted incompressible stripe elements as described in Fig. 10. The polarity of the voltage induced at each stripe element is determined by the polarity of $E_y$ induced by the left sample edge and by $B_z$, which both are the same for each element. Therefore, the polarity of each element is the same, and the induced voltages of the elements add up constructively as shown to yield a voltage between the outermost contacts (8).

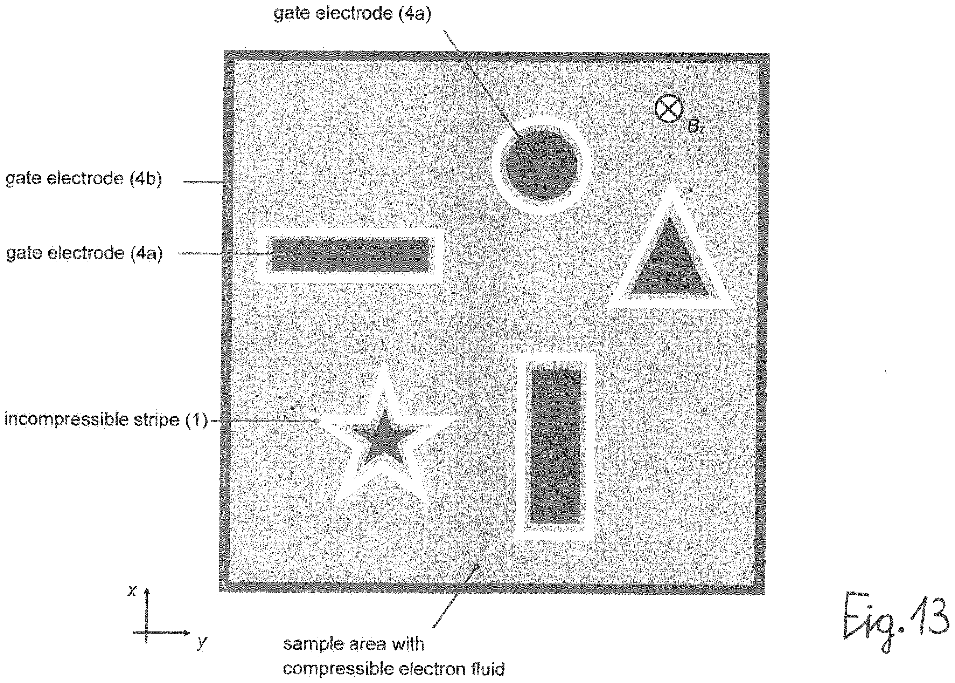

Fig. 13 shows an illustration of the top view of a QHE sample subject to a magnetic field $B_z$ chosen such that the main part of the sample contains a compressible electron fluid. In this example, the formation of an incompressible stripe at the sample edges is prevented by the positively charged gate electrode 4b placed close to sample edge. Five further, arbitrarily shaped gate electrodes 4a placed on the sample surface that are negatively charged, possibly with different gate voltages, are used to induce corresponding incompressible stripes in the interior of the sample, away from the sample's edges.

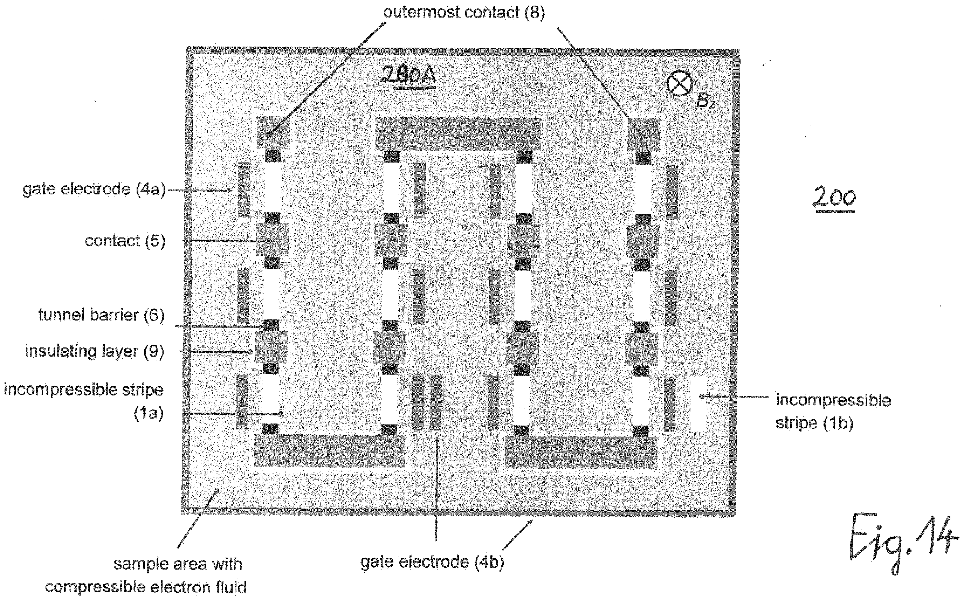

Fig. 14 shows an example of an array according to the second aspect, in particular a top view of a QHE sample subject to a magnetic field $B_z$ chosen such that the main part of the sample contains a compressible electron fluid. The sample shows a series connection of contacted incompressible stripe elements 1a distributed across the surface area of the sample. The incompressible channels are induced in this case by means of the gate electrodes 4a which in this example are charged negatively with respect to the sample. The contacts 5 are placed on insulating layers 9 to isolate them from the semiconductor. As illustrated at the right side of the figure, the negatively charged gate electrode 4 may induce a second incompressible stripe 1b that, depending on the sample layout, may not be desired. As illustrated at the bottom of the sample, the formation of such undesired incompressible stripes 1b can be suppressed by adding further, positively charged gate electrodes 4b to the sample which screen the electric field of the negatively charged gate electrodes 4a.

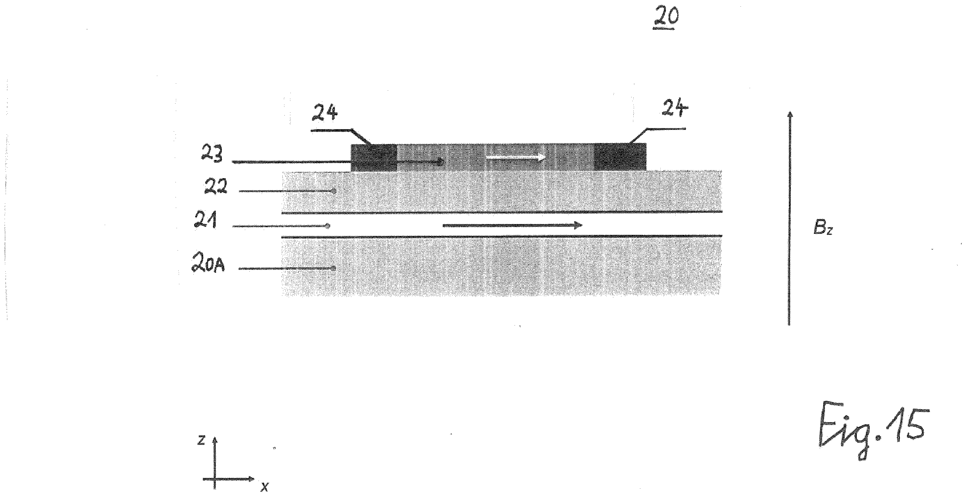

Fig. 15 shows an illustration of the cross-sectional view of a QHE sample subject to a magnetic field $B_z$ chosen such that the main part of the sample contains an incompressible electron fluid. In this incompressible fluid an electric current is flowing in thermal equilibrium (large arrow). This current is coupled via a barrier to a further conductor. This coupling induces a current to flow also in the further conductor (small arrow). If the further conductor is restricted by two contacts as shown, a voltage builds up between these contacts.

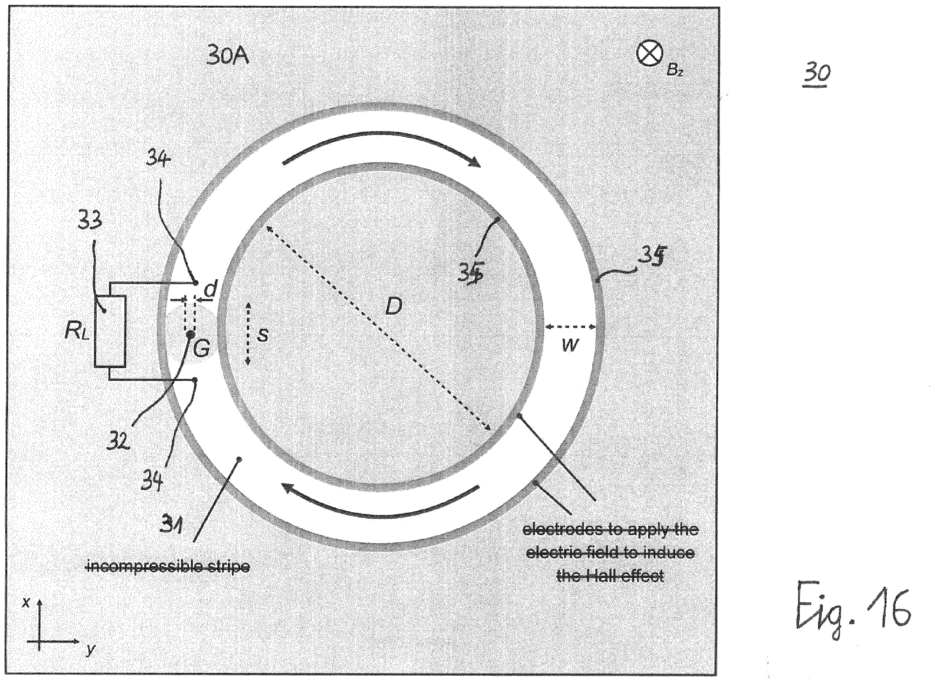

Fig. 16 shows a top-view of a QHE sample subject to a magnetic field $B_z$ chosen such that for the applied electric Hall field in undisturbed thermal equilibrium a current is circulating around the ring-shaped incompressible stripe of diameter D and width $w$. The device includes a gate electrode G drawn as a small black dot of diameter d, deposited on top of a gate insulator grown on top of the ring. If charged, the gate electrode creates a carrier-depleted area of diameter s > $w$, such that the circulating current now passes through the shunt resistor $R_L$.

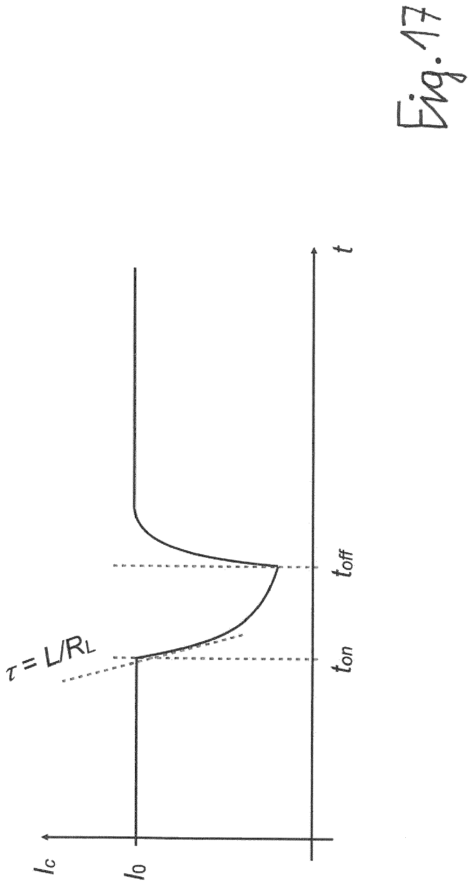

Fig. 17 shows a diagram showing as a function of time t the value of the electric current circulating in the incompressible ring displayed in Fig. 16. The gate electrode is only charged for $t_{on}$ < t < $t_{off}$. During this time, the circulating current passes through $R_L$ and decays with a time constant $\tau$ that is proportional to the inductance L of the ring.

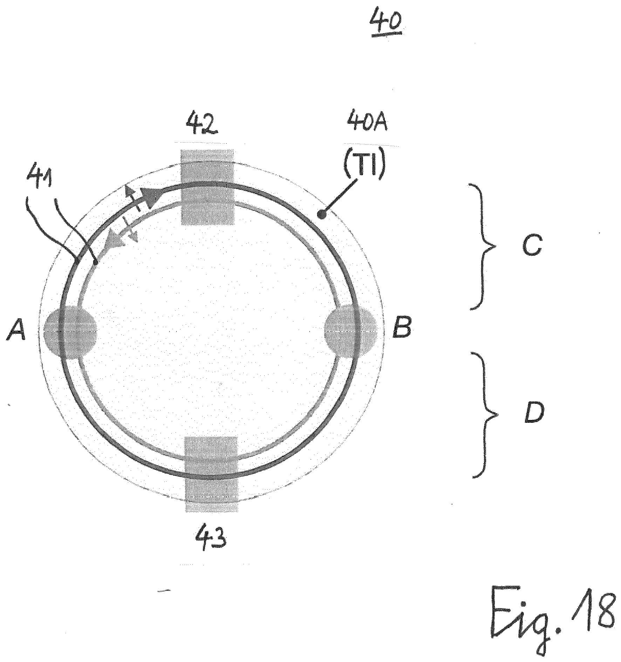

Fig. 18 shows a schematic top view on an example of a quantum device according to the first aspect, in which device use is made of chiral surface currents flowing along the edges of a topological insulator, wherein these chiral surface currents are locally coupled to a spatial area containing inelastic scattering centers.

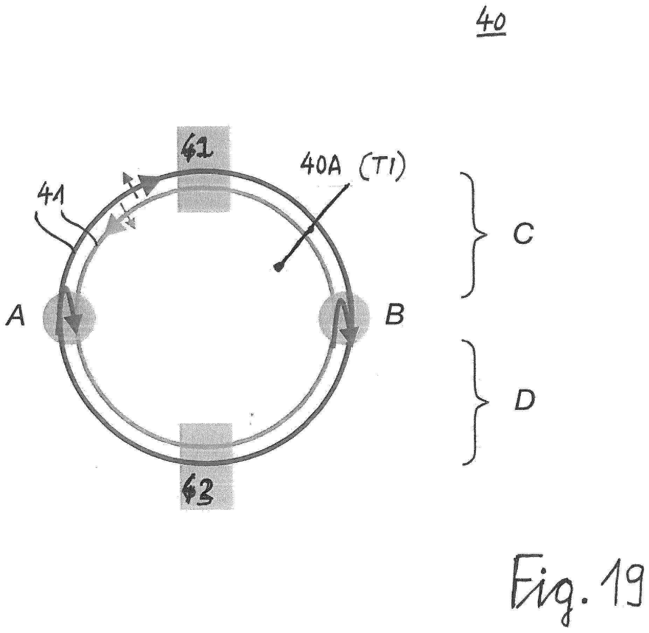

Fig. 19 shows the quantum device according to Fig. 18 further illustrating the operation of the device in which operation electrons are flowing from area C to D at a higher rate than from D to C.

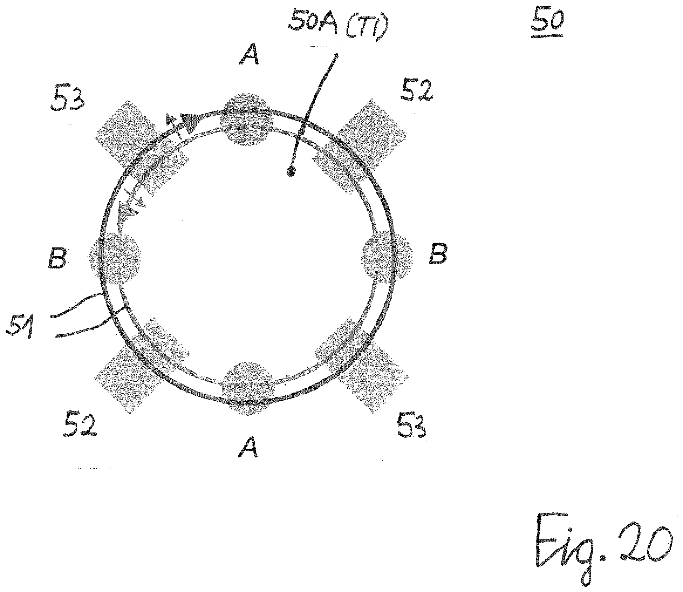

Fig. 20 shows a further example of a quantum device according to the first aspect, which quantum device represents a further development of the quantum device according to Fig. 18, namely adding further terminals as well as inelastic scattering centers.

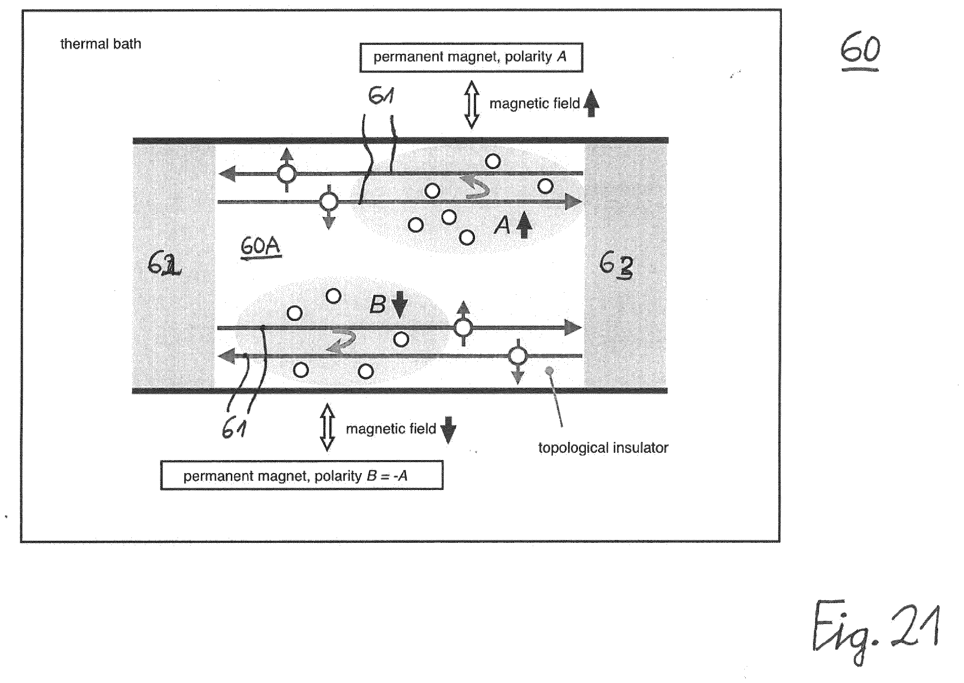

Fig. 21 shows a further example of a quantum device according to the first aspect. The device makes use of a topological insulator equipped with two contacts 1, 2 and embedded in a thermal bath. At its upper and lower edges, the topological insulator forms chiral edges states which carry spin-polarized electrons as drawn.

## DETAILED DESCRIPTION

A characteristic of all quantum devices presented hereafter is that the respective quantum devices are adapted to extract heat energy from a surrounding heat bath and to convert the heat energy into the generation of the currents. Moreover, the quantum devices are adapted to generate the currents even when the at least two terminals of the quantum device are held at one and the same temperature. In particular, the quantum devices can have a non-reciprocal transmission structure, which means that in one direction between the contacts the particle current is stronger than in the other direction. Some of the quantum devices, namely the quantum devices working on the basis of the quantum hall effect need the application of a magnetic field, some others the application of an additional electric field in order to induce the quantum hall effect, and some other quantum devices require neither a magnetic nor an electric field.

The problem of using nonreciprocal electron transmission to convert heat into a difference of the electrochemical potential of two contacts in a macroscopic device that does neither require sample patterning of the resolution mentioned nor orienting the nanodevices by means of one or several fabrication steps is solved by appropriately combining electrically conducting channels that carry dissipationless, i.e. nominally loss-free, macroscopic electric currents with incoherent electron systems characterized by non-unitary, dissipative charge transport. The dissipationless channels are, for example, obtained by using structures that show a Quantum Hall Effect (QHE) or a related topological phenomenon. While in explaining the present disclosure we will use in the following examples based on solids consisting of an n-doped semiconductor held in thermal equilibrium at a temperature T, the present disclosure is not restricted to n-type semiconductors.

1. Generation of dissipationless macroscopic currents

It is well known that a variety of topological phenomena in two-dimensional (2D) or three-dimensional (3D) solids are associated with dissipationless currents flowing in thermal equilibrium along closed loops along the edges or surfaces for two-dimensional (2D) and three-dimensional (3D) solids, respectively, as exemplified in Figs. 1, 2. Examples of such topological phenomena are given by the Integer Quantum Hall Effect, the Fractional Quantum Hall Effect, the Anomalous Quantum Hall Effect, by the Quantum Spin Hall Effect generated by 2D topological insulators, and by surface currents of 3D topological insulators. The transport along the sample edges or surfaces is frequently explained by mentioning the surface bands crossing the chemical potential in the samples' band structures (see Fig. 3). These surface bands are determined by the topological properties of the solids.

Before moving on explaining the present disclosure it appears necessary to give a definition of the term "topological material".

Following the usage in the literature [B. Yan and S.-C. Zhang, Rep. Prog. Phys. 75, 096501 (2012); C. Choi, Spectrum IEEE, p. 6, July 2021], the term 'topological material' is used to refer to a material with an electronic structure characterized by at least one property countable in integral numbers, such that said property cannot be changed in a continuous manner without a qualitative change of the band structure, and said integral number not being the same as that of a trivial material such as Si, air or vacuum. Said numbers are called topological numbers, examples are given by the so-called 'TKNN invariant' or 'Chern-numbers' [M.Z. Hasan and C.L. Kane, Rev. Mod. Phys. 82, 3045 (2010); M. Franz, L. Molenkamp, *Topological Insulators,* Elsevier, 2013]. Specifically, for the integer and anomalous quantum Hall effects, the topological number is given by the number of completely filled Landau levels. For topological insulators, a commonly used topological number, the so-called $Z_2$ invariant, refers to whether the number of electronic bands that cross the band-gap between two Kramers degenerate points is even (topologically trivial material) or odd (topological material).

The qualitative change of the band structure is, in most cases, given by the vanishing of the band gap at the electrochemical potential. Hence, if two materials with different topological numbers are joined at an interface, the interface will be conducting due to said vanishing of the band gap, even if the inner of the materials is insulating. If one material is air, the interface is the material's surface and surface conduction is obtained. The existence of such interface or surface states is denoted as being 'topologically protected' or "protected by symmetry properties".

Further, interface states of topological materials may carry dissipationless currents, as is the case, for example, for the incompressible stripes of quantum Hall devices. Also in the case of topological insulators, interface or surface states may carry currents that in the absence of inelastic and spin-flip scattering flow without dissipation. These currents are the currents that are shown in Fig. 1 to flow along the edges of the devices.

Furthermore, in the case of topological insulators with a spin-orbit coupling energy, the direction of a moving electron's spin is coupled to the direction of the electron's motion by spin-orbit coupling. Such currents are called chiral surface currents. The dispersion relation of these currents is linear at the electrochemical potential; the absolute value of the electron velocity is therefore constant. This implies that the absolute value of the current density is proportional to the electron density.

Topological materials exist in two or three spatial dimensions. For 2D topological materials (shown in Fig. 1) the interface or surface states are 1D states extended along the sample's edges, for 3D topological materials (see Fig. 2), the interface or surface states are 2D states that are extended along the sample's surface.

To appreciate the gist of the present disclosure it is necessary to consider the microscopic mechanism driving this current flow in greater detail than made available by such band diagrams only. The understanding of these currents is most advanced and experimentally corroborated for the case of the QHE. While in explaining the present disclosure we will therefore focus on the QHE, the present disclosure itself is not restricted to the QHE but also refers to the further phenomena in which in thermal equilibrium macroscopic dissipationless currents are induced.

The state-of-the-art understanding of the QHE is provided by a model that we will refer to as 'incompressible stripe model'. Pioneering work on this model was done by the discoverer of the QHE, Prof. v. Klitzing and his group, as described in [v. Klitzing, 2005a; v. Klitzing, 2005b; Gerhardts, 2008; Gerhardts, 2009; Weis, 2011; Panos, 2014; v. Klitzing, 2017]. As explained in [v. Klitzing, 2005b; Weis, 2011; v. Klitzing, 2017], this understanding improves on the incorrect 'skipping-orbit model' developed previously by Büttiker (Büttiker, 1988), which is mentioned here only, because this skipping-orbit model is frequently found in older textbooks.

The incompressible stripe model has advanced the understanding of the generation of the dissipationless macroscopic currents in the QHE as will be summarized in the following. In a semiconductor sample that is oriented perpendicular to a magnetic field $B_z$ and has an electronic mean free path much larger than cyclotron radius $l_e \gg r_c$ corresponding to $B_z$, the electron states form Landau cylinders (illustrated in Fig. 3a,b) the energies of which are given by the Landau levels. While in thermal equilibrium the electric potential $\varphi_e$ is constant in the interior of most of the sample, it increases at the samples edges, forming a depletion layer with a width of the order of the semiconductor's Debye length. As a result, the sample develops at its edges alternating stripes of incompressible compressible electron fluids, henceforth called incompressible and compressible stripes (Fig. 4). In an incompressible stripe, the chemical potential rests between a completely filled and a completely empty Landau level, v being the number of completely filled Landau levels. The number of incompressible stripes is given by the value of $u$. Of these incompressible stripes, usually only the one farthest from the sample edge may carry a dissipationless current. In the following, we therefore focus on that stripe with no loss of generality.

The band bending at the sample edges results in an electric field $E_y$ oriented parallel to the y-direction, i.e. perpendicular to the stripe direction (Fig. 5). This field penetrates the stripe and causes the electron states to drift in the direction of the stripe to yield an electric current flowing parallel to the x-direction along the stripe. This is the somewhat unintuitive motion of an electron in an electric field and in a magnetic field perpendicular to it: In a semi-classical picture, an electron at rest at the start is accelerated by $E_y$, left edge in the -y-direction). Since it then moves with finite velocity in the -y-direction, a Lorentz force acts in the x-direction due to $B_z$. So the electron makes an arc in direction x, but then the Lorentz force acts to -y, and so on. As a result, the electron follows a cycloidal path, which leads the electron in the x-direction on the average.

The value of this current in x-direction is given

$$J_x = v\frac{e^2}{h}E_y$$

by its linear current density . This current circulates along the incompressible stripe, which thus forms a closed loop around the sample (Fig. 5 or Fig. 1, left panel). This current flows without dissipation, as it is induced in the ground state of the system. From a microscopic point of view, losses are absent because electronic scattering within a stripe is suppressed by the gap between the Landau levels. Electron scattering between incompressible stripes at opposite sample edges is disallowed by the macroscopic distance between these stripes.

As described for the incompressible stripe to be generated and for the dissipationless current to flow, the band bending and the associated electric field $E_y$ are essential. It is noted, that such a band bending and electric field can also be induced far from the sample edges, for example by using gate electrodes, as illustrated in Figs. 13, 14. The freedom given in designing a gate electrode or a multitude of gate electrodes, choosing their locations on the sample also away from the sample edges in the interior, and choosing their respective gate voltages is advantageous for many applications, as by this, for example, also the interior of the sample can be used to generate the desired outcome. By the same argument it is clear that gate electrodes placed onto the sample that are charged with a suitable voltage can be used to suppress the formation of stripes.

It is also to be appreciated that in polycrystalline samples not only the outer edges and surfaces of the entire polycrystal may be used as sample edges, but also the grain boundaries inside the polycrystal, because these act as edges or surfaces of the individual grains. The same applies for twin-boundaries in corresponding single crystals.

## 2. Cutting the loop of the incompressible stripe

As next step in explaining the present disclosure we emphasize that the existence of the QHE rests on the condition $l_e \gg r_c$ introduced above. In case the electron mean free path $l_e$ is sufficiently small, which can be arranged by, for example, introducing defects or impurities into the semiconductor by irradiation or by diffusion, the semiconductor acts as a well-known standard semiconductor subject to a magnetic field $B_z$. For the clarity of the argument we constrain ourselves to consider here only the idealized case in which beyond the reduction of $l_e$ all other sample parameters such as the electron density or dielectric properties remain unchanged. This electronic phase with reduced $l_e$ we will call 'normal phase'.

It is apparent that by using lithographic patterning techniques the sample may be changed to comprise both a part with a large $l_e$ as required for the QHE effect, and a part with a small $l_e$ that provides a normal phase. One possible geometrical configuration is shown in Fig. 6. By patterning, a sample has been constructed in which the incompressible stripe does not form a closed loop anymore. This remaining stripe is oriented in x-direction. The rest of the sample consists of the normal semiconductor, devoid of Landau levels and of the QHE. Therefore, an incompressible stripe cannot be formed in this rest of the sample, and no dissipationless current flow is possible there, as is also obvious from energy level diagram of that system (Fig. 7). It is to be appreciated that the patterning required to obtain the desired structure does only need moderate resolution, as the width of the incompressible stripe is typically on the order of 0.1 $\mu$m or, more generally, greater than 0.05 $\mu$m.

An alternative approach to obtaining an incompressible stripe that does not form a closed loop is as follows. Instead of reducing $l_e$ in parts of the sample, one or several gate electrodes are used to locally suppress the band bending, for example at one side of the sample (in Fig. 8 the right side), thereby quenching the aforementioned depletion layer. While in this case the sample remains completely in the QHE state, the loop provided by the incompressible stripe is interrupted next to that gate electrode, as is also obvious by considering the energy level diagram of that system (Fig. 9).

In each of the two cases, the achieved sample consists of a double-ended incompressible stripe in electric contact with an ohmic conductor which is given by the compressible electron phase of the QHE state or by the normal phase.

3. Contacting the incompressible stripe

We now move on to consider the effect of establishing two contacts between the stripe and the ohmic semiconductor. While an incompressible stripe may be contacted in various ways, for the sake of the argument we assume here that the contacts are mediated by two optional tunnel barriers as shown in Fig. 10. An arrangement as shown in Fig. 10 we henceforth will call 'stripe element'.

4. Behaviour of a stripe element

In a first step, the electric field $E_y$ that is induced by the band bending at the sample edge generates a drift current $J_x = \nu \frac{e^2}{h} E_y$ as described. This drift current consists of a coherent motion of electrons, as described by unitary quantum physics. In case the stripe had no contacts, this drift current could not leave the stripe. In the no-contact-case, a situation therefore arises in which an inhomogeneous carrier distribution in the stripe builds up an internal electric potential in the stripe. As result of this internal electric potential, the drift current is cancelled.

Contacts provided to the sample change this situation. In this case, the drifting electrons arriving, for example at the lower contact shown in Fig. 10 may tunnel through the tunnel barrier and occupy an available free state in the electron density of states of n-type semiconductor that provides the lower contact. This semiconductor is characterized by the Fermi-Dirac distribution for the occupancy of the states at finite T.

With electrons leaving the stripe at the lower contact, the electrons in the stripe drift downward in -x direction, and are replenished at the upper contact by thermally excited electrons that tunnel from the upper contact into the stripe. The process of electrons moving into the stripe or out of the stripe is an incoherent, inelastic process. It typically involves thermal excitation or a continuous density of electron states: Therefore, the device operation involves a combination of coherent electron transport as described by the Schrödinger equation and an incoherent transport, suitably described by Born's rule or by Fermi's golden rule. In the case discussed here as example, the transition between both transport processes occurs right at the transition between the incompressible state and the contacts. In other cases, however, the transition may occur at different locations, for example in the contacts themselves, in case parts of them host a coherent electron system. By this action electron charges build up in the lower contact, and electrons are partially removed from the upper contact. The difference between the electron densities in both contacts yields a difference in their electrochemical potential, i.e. finite voltage is built up between the upper and lower contacts.

Hence Fig. 10 shows an example of a quantum device according to the first aspect, the quantum device 10 comprising a semiconductor sample 10A, e.g. a silicon sample 10A, to which a magnetic field perpendicular to the main surfaces of the semiconductor sample is applied, the semiconductor sample 10A thus being capable of showing the quantum hall effect and thus being an example of a topological material. The quantum device 10 further comprises a non-reciprocal transmission structure 1 which in this embodiment is an incompressible stripe 1 which is provided as explained before. The quantum device 10 further comprises two terminals 5, namely the contacts 5 connected at opposing ends with the non-reciprocal transmission structure 1. The non-reciprocal transmission structure 1 is adapted to generate currents of electrons between the at least two contacts 5, and in this embodiment the two contacts are adapted to inelastically scatter at least a part of the currents in a dissipative manner.

In the embodiment shown in Fig. 10, there are two compressible stripes 2 on both sides of the incompressible stripe. In principle, however, the compressible stripes 2 are not necessary for the actual function of the component. It is quite possible to build devices which contain only one compressible stripe 2 (the stripe near the sample edge). However, the existence of this compressible strip is a rather parasitic effect.

If the two contacts 5 are connected to each other via a load, e.g. if a lamp is connected to the contacts 5, then the following circuit results: the incompressible stripe 1 'generates' a current, the current flows only in this incompressible strip 1 without dissipation. This current enters a first contact 5, the electrons are inelastically scattered there. Then the current flows across the lamp to the second contact 5 and finally back into the incompressible stripe 1. It is also possible to deliberately introduce a small amount of dissipation into the incompressible stripe 1, so that the current does not flow there completely free of dissipation.

It is noteworthy that the incompressible stripes can be induced also in the sample interior, i.e. away from the sample edges or surfaces, by means of gate electrodes, as illustrated in Figs. 13, 14. Further, the 2D electron system may be deliberately destroyed locally by etching away part of the semiconductor's multilayer that host the 2D electron system. The use of gate electrodes or of chemical etching structures, defined e.g. by photolithography, therefore provides the possibility to freely place the incompressible stripes all across the sample, and by this harness a larger sample area to generate the electric power.

It is also noted that the efficiency of the electron transport into the contact materials can be enhanced by using tunnel barriers with high transparency, or by providing a high density-of-states in the contact materials. If the contacts would be left open, i.e. without further connections, the finite voltage would again influence the charge distribution in the incompressible stripe and, by this, quench the drift current.

Yet, the contacts are in contact to the ohmic parts of the sample given by compressible stripes and by the normal phase. In that case, the electrons will flow through the ohmic part of the sample from the bottom contact to the top contact, yielding an internal ohmic current $I_{shunt}$.

5. Attaining an output voltage or output current

If the contacts, preferably the two outermost contacts 8 (see Fig. 12), were connected to an external load, a part of the flowing charge determined by Kirchhoff's laws will pass through the external load and thus provide an output power of the device. It is obvious, that this output power can be enhanced by choosing a sample design in which $I_{shunt}$ is minimized, in the most straightforward case by cutting a multitude of slits into the sample as shown in Fig. 11.

It is emphasized that the polarity of the induced voltage is determined by the direction of $B_z$ and by the polarity of $E_y$, and thus is the same at any point of a given sample edge. For this reason, it is straightforward to fabricate arrangements of many strips connected with the correct polarity (see quantum devices 20 and 30 in Figs. 12, 14, respectively).

6. Further implementations

The devices revealed above utilize the combination of one or a multitude of incompressible stripes 1 and contacts 5, as by means of example shown in Figs. 10, 12 and 14.

The combination of electric currents flowing in the ground state of an electronic system and incoherent processes may, obviously, also be used in further device configurations that differ from the example illustrated in Fig. 10, as shown by the following two further examples:

*I) Devices characterized by voltages and/or currents generated in conductors in proximity to an incompressible stripe*

Fig. 15 shows a cross-section through a quantum device 20 that comprises a semiconductor sample 20A, an electron system forming an incompressible stripe 21 with a current flowing in the ground state of the system, a barrier layer 22, and a further conductor 23. The barrier layer 22 couples the electron systems of the incompressible stripe 21 and the further conductor 23, for example by electron tunnelling or by phonon exchange.

The further conductor 23 is, in this example, an ohmic conductor 23 such as an n-doped semiconductor with a mean free path shorter than its magnetic length, such that it does not form Landau levels or show the quantum Hall effect. Due to the coupling between the incompressible stripe 21 and the further conductor 23, electrons that move in the incompressible stripe 21 with a velocity in x-direction as given by the value of the flowing current tend to induce an electron drift in the further conductor 23. This induction is done by electrons tunnelling with a finite drift velocity from the incompressible stripe 21 into the further conductor 23, or by the electrons in the incompressible stripe 21 inducing first a finite drift velocity in the phonon system, which then induces a finite drift velocity in the further conductor 23. By the same token will the electron system in the further conductor 23 slow down the electron drift in the incompressible stripe 21.

The electron current thereby induced in the further conductor 23 will induce a voltage between two contacts 24 placed at the two ends of the further conductor 23. In the steady state, this voltage will suppress the current flow in the further conductor 23. Yet, the output voltage can be used to operate an electric device. The load of this device reduces the output voltage, such that again a current is induced in the further conductor 23. By flowing through the electric device, this current flows in a loop.

It is needless to say that the further conductor 23 may also be placed in lateral proximity to the incompressible stripe 21, that a multitude of further conductors may be utilized to enhance the output, or that the further conductor 23 may be placed in direct proximity to the incompressible stripe 21 without a barrier layer 22 fabricated on purpose. Indeed, even the compressible stripes may be used as further conductors. The barrier layer 22 could also itself be comprised of a compressible stripe at the edge of the semiconductor device.

*II) Devices characterized by temporary interruptions of the current flow in an incompressible stripe*

To understand the operation of such further quantum devices the function of which is attained by temporary interruptions of the current flow in an incompressible stripe, two facts ought to be recalled:

    a) The carrier density of a 2D electron system can easily be tuned, even to complete depletion, using a field effect transistor arrangement, in which a charge added to a gate electrode alters the carrier concentration of the 2D electron system. Such field effect transistors operate with power amplification. To turn a large current on or off, only very little power is needed.

    b) A current flowing in an incompressible stripe induces a magnetic field; the current is therefore associated with an inductance $L$. For a straight strip, $L$ increases linearly with the length of the strip, for a loop, L increases with the diameter of the loop.

The operation of respective further quantum devices according to the first aspect is explained by using Figs. 16 and 17. In the example shown, a quantum device 30 comprises an incompressible stripe 31 forming a loop in the xy-plane in a layer near the surface of a semiconductor sample 30A, e.g. a silicon sample 30A. Furthermore, such a device 30 includes a gate electrode (G) 32 with a diameter d much smaller than the width $w$ of the incompressible stripe 31. The gate electrode 32 can be electrically charged to completely deplete an area with a lateral size s > w into an insulating state with a potential barrier such that charge carriers cannot cross said area. Said area is furthermore shunted by a load resistor 33 with ohmic resistance $R_L$. Electrically conductive electrode layers 34 are provided on inner and outer surfaces of the incompressible strip 31. An electric field can be generated with the electrode layers 34 to induce the hall effect.

Fig. 17 shows as function of time the current I circulating through the device. The gate voltage is zero except for the times $t_{on}$ < t < $t_{off}$ during which the gate is charged to provide complete depletion as described above. For t< $t_{on}$ a constant current $I_0$ is circulating in the ring given by the incompressible stripe according to its equilibrium state. At $t_{on}$, the passage of the current through the depleted area becomes blocked. However, given the inductance L, the circulating current can only change with a time constant $\tau$ as resulting from the device inductance. While decreasing in value, the current therefore bypasses the gated area by flowing through the ohmic resistor $R_L$ 33. Due to the dissipation induced by $R_L$, the circulating current decays with a time constant $\tau = L/R_L$. At $t_{off}$, the gate is turned off again, and the current, now again flowing completely in the incompressible stripe 31, returns to its original value $I_0$.

It is appreciated that the maximal gate voltage needed to block the current flow under the gate scales with $I_c R_L$, the maximum voltage that can occur along the resistor 33 or across the depleted area under the gate 32. This limit does not depend on the inductance L and therefore also not on the diameter D of the ring. Because the square of that voltage determines the maximal energy $E_{gate}$ to charge the gate capacitor to block the current flow, said energy is also independent of L or D.

It is also appreciated, that during $t_{on}$ < t < $t_{off}$, in which the current is flowing through $R_L$, electric energy is dissipated in the resistor $R_L$ 33 and heat is there generated. If said ohmic resistor 33 was replaced by an electric appliance with an ohmic characteristic, this appliance could perform work as determined by said energy. Said energy scales with the product of the time-averaged power dissipated in $R_L$ as given by c $I_c^2 R_L$ and the time constant $\tau = L/R_L$ : $E_{out} = c\ I_c^2\ R_L \times L/R_L = c\ I_c^2\ L$. Here, $c \approx 1/e^2$, where e is Euler's constant, is a constant factor. It is important to note that by increasing D and thereby L, $E_{out}$ can be increased at wish, while $E_{gate}$ does not increase with D. For large D, $E_{out}$ therefore exceeds $E_{gate}$.

Thus, if operated by repeatedly switching the gate, on time average a net power is provided by the device to $R_L$. The repetition of the gate switching could also be provided by the thermal noise induced by an ohmic resistor, in particular if said ohmic resistor is connected in series with a bias voltage. Further, the device may be operated at such high temperatures T, that kT-driven charging processes of point or line defects cause the formation of depletion zones as shown in Fig. 16.

Hence Fig. 16 shows a further example of a quantum device according to the first aspect, the quantum device 30 comprising a semiconductor sample 30A, e.g. a silicon sample 30A, to which a magnetic field perpendicular to the main surfaces of the semiconductor sample 30A is applied, the semiconductor sample 30A thus being capable of showing the quantum hall effect and thus being an example of a topological material. The quantum device 30 further comprises a non-reciprocal transmission structure 31 which in this embodiment is an incompressible stripe 31 which is provided as explained before. The quantum device 30 further comprises a further element 33, namely the load resistor $R_L$ 33 which is connected with the non-reciprocal transmission structure 31 by two terminals 34 which are positioned on opposing sides of the gate electrode 32. In this embodiment the non-reciprocal transmission structure 31 is adapted to induce currents of electrons in the load resistor $R_L$ 33, and in this embodiment the load resistor $R_L$ 33 is adapted to inelastically scatter at least a part of the currents in a dissipative manner. Hence in this embodiment only the current induced in the load resistor $R_L$ 33 by the dissipationless current flowing in the incompressible stripe 31 is utilized for generating an external voltage or current and not the dissipationless current itself.

7. Extension to other systems

The explanation above was given for the example of the integer QHE. However, the present disclosure is not restricted to integer QHE devices, but refers in general to any sample or phenomenon in which dissipationless macroscopic surface currents are induced, as explained in the following using the examples of the fractional QHE, the anomalous QHE, and the Quantum Spin Hall Effect. More systems exist, for example Chern insulators.

First we note that the present disclosure will work without changes for the fractional QHE, as the above explanation is exactly valid also in this case.

For the anomalous QHE (Fig. 1C) the present disclosure works also the way as described, with the difference that due to the internal magnetization of the sample, there is no need for the application of an external B. For the case of the Quantum spin Hall effect (Fig. 1B), the surface current comprises two counter-circulating currents of electrons with opposite spin orientation, so-called chiral edge modes. There is no need for an application of a B-field. If devices are fabricated and operated as described above (without a B-field), electrons of one spin direction will accumulate in one contact, the electrons of opposite spins in the other. This behaviour is of value to separate electrons of different spin direction and to generate magnetic dipoles. Net voltages and currents will be generated, if the symmetry between the electron population numbers of the two spin directions is broken, for example by applying a *B*-field, by introducing spin-dependent scattering into the samples, or using further spin polarizers or analysers.

In a further implementation of the present disclosure, use is made of the chiral surface currents flowing along the edges of a topological insulator. In the standard case, two chiral currents with opposite spin directions circle the sample in opposite directions, as shown in Fig. 1B.

Fig. 18 shows an implementation of a quantum device 40 based on a disk-shaped topological insulator 40A (TI) with two chiral currents circulating at its edge in opposite direction. The directions of the electron flow in the chiral channels are given by the triangles. The clockwise circulating chiral current is provided by electrons with a spin pointing downward in the plane of the topological insulator 41, the counterclockwise flowing current is provided by electrons with an upward spin direction. The device 40 comprises two areas A, B that generate spin-flip scattering. Area A scatters preferentially up-spins into down-spins, area B scatters preferentially down-spins into up-spins. The upper half of the device (C) is connected by contact 42, the lower half by contact 43.

Hence in this implementation of the present disclosure, these chiral surface currents are locally coupled to a spatial area containing inelastic scattering centers *A*, *B* which provide spin-flip scattering. Such inelastic scattering centers may, for example, be provided by impurity states or by quantum dots, both associated with magnetic moments. For a high density of spin-flip scattering centers, the scattering leads to unwanted Anderson localization. Therefore, preferably a scattering center density is chosen that is smaller than the material-dependent value required for Anderson localization.

In the implementations, at least one such scattering area is provided in which the scattering process has a preferred direction, such that, e.g., scattering an up-spin to the down-direction is more likely than scattering a down-spin to the up-direction. The preferred directionality of the scattering process, may, e.g., be implemented, by preferentially aligning the magnetic moments of the impurity states or spins by a magnetic field applied locally, for example by means of a permanent magnet.

As shown in Fig. 18, the device 40 is equipped with at least two such scattering areas. For the case shown in Fig. 18, one area (A) has a preferred spin scattering direction up-to-down, the other area (B) down-to-up. The device is furthermore equipped with two contacts 1 and 2 that are placed in each of the two spatial sections C and D of the chiral surface currents that connect A and B.

The flow of the chiral currents as sketched in Fig. 18 corresponds to the conventional case of equal current densities. This case provides a constant electron density in the current paths, with the two contacts 42, 43 being at the same electrochemical potential. Due to action of the spin-flip areas A and B the situation of Fig. 18 is not stable, however, because A and B will divert the chiral currents as shown in Fig. 19. As a result, starting with a constant electron density, electrons are flowing from area C to D at a higher rate than from D to C. A new steady state is therefore established, in which a difference of the electron density between C and D and therefore a difference in the electrochemical potential between C and D arises such that a dissipative back-flow of electrons from D to C is induced which creates a new equilibrium of currents. Effectively, as compared to the start of the process, the action of A and B has resulted in pumping electrons from C to D. Said difference of the electrochemical potential is delivered to contacts 42 and 43 and is available to drive an external load.

Fig. 19 thus reveals the result of the action of the spin flip scattering processes occurring at A and B. At A counterclockwise circulating electrons are flipped into clockwise circulating electrons (see curved arrow) and are therefore prevented from entering area C. At B clockwise circulating electrons are flipped into counterclockwise circulating electrons (see curved arrow) and are therefore also prevented from entering area C. As a result, the electron density is decreased in C and enhanced in D, leading to an electric voltage between contacts 42 and 43.

It is obvious that the difference of the electrochemical potential or, if a load is provided, the output current of such a device benefits for example from a large value of the surface currents flowing in the sample prior to the addition of *A*, B. Therefore, the useful effects described can be optimized by using topological insulators with large chiral currents or with large gains of free energy associated with these chiral currents.

Hence Fig. 18 shows a further example of a quantum device according to the first aspect, the quantum device 40 comprising a topological insulator 40A being an example of a topological material. The quantum device 40 further comprises a transmission structure 41 which in this embodiment is comprised of the chiral channels of counter-propagating electrons. The quantum device 40 further comprises a region of the topological material, namely the inelastical scattering centers A and B, which are adapted to inelastically scatter at least a part of the currents in a dissipative manner.

The case shown in Fig. 18 by way of the example shown is just a special case of the generic principle of this implementation of the present disclosure. For example, the device will also work even if one of the areas A or B has no preferred spin-scattering direction. In that case, the steady case situation will yield in addition to the mentioned difference in electrochemical potential a net chiral circulating current around the sample, which generates a magnetic field.

Further, the device will work with greater effect if several of the A-B areas and contacts 52 and 53 are added to the sample, as shown in Fig. 20. The quantum device 50 comprises a topological insulator 50A (TI) such as the topological insulator 50A that shown and described with the quantum device 40 of Figs. 18 and 19, several scattering centers A and B, and several contacts 52 and 53. The quantum device 50 is thus based on the principles of the quantum device 40 shown in Fig. 18. In the configuration shown in Fig. 20, the presence of a multitude of scattering centers A, B and contacts 52, 53 yields a larger device output.

Further, several devices as shown in Figs. 18 and 20 may be combined in series, in parallel or in network manner, which also may include stacking in the third spatial dimension.

Further, it is obvious that the principle here explained for the case of a 2D topological insulator can also be applied with the benefit of enhanced output to 3D topological materials and other topological materials. For 3D topological materials, the areas A and B and the contacts 42 and 43 may have the shape of stripes crossing a surface perpendicular to the direction of the surface current flow. Current back-flow along surfaces that provide unwanted current shunts may be minimized by reducing the conduction along such surfaces by adding additional inelastic or magnetic scattering centers.

It is also emphasized that the arguments presented are not restricted to the edge or surface currents consisting of moving electrons. The mechanism revealed applies equally well to moving holes. It will also apply to cases in which these currents comprise other quasiparticles such as spinons, magnons, phonons, polarons, or polaritons should those be discovered in the future or already have been so.

Fig. 21 shows a further example of a quantum device according to the first aspect. The device makes use of a topological insulator equipped with two contacts 1, 2 and embedded in a thermal bath. At its upper and lower edges, the topological insulator forms chiral edges states which carry spin-polarized electrons as drawn. The electrons are drawn using small open circles, their spins are designated by the arrows pointing up or down, the electrons' directions of motion by the arrows pointing left or right. The inelastic scattering centers, spatially grouped into two areas A and B, are sketched with the open circles. The spin-flip direction of these scattering centers is controlled by means of magnetic fields applied to areas A and B with directions indicated by the bold arrows.

Here, it is worthwhile to note that in A.M. Bozkurt et al., Phys. Rev. B 97, 245414 (2018) and WO 2018/027243 A1 spin-flip scattering of electrons traveling within chiral edge channels of topological insulators is used to implement a battery function, i.e., to obtain a device that delivers an output current via a discharge after being charged with a charging current.

While similarities to the embodiment according to Fig. 21 exist, the device of A.M. Bozkurt et al., Phys. Rev. B 97, 245414 (2018) and WO 2018/027243 A1 functions in a manner that differs fundamentally from the present disclosure. This becomes obvious by noting that the device of A.M. Bozkurt et al, Phys. Rev. B 97, 245414 (2018) and WO 2018/027243 A1 is a battery, the core function of which is based on a memory resource that stores information which changes by spin-flipping each time a backscattering event occurs. The battery operation furthermore requires a driving phase in which the device is charged by means of charging the memory resource with a current. Further, the battery does neither require thermal excitation, nor inelastic scattering processes, nor a thermal bath, does not make use of an inhomogeneous spatial distribution of the nuclear spins or dopants spins implemented, and does not rely on or make use of predefined preferential spin-flip scattering directions.

In contrast, the devices of the present disclosure are thermal generators, not batteries and have a different architecture. They do not require a memory resource to store information, they do not need a charging current. In contrast, they require thermal excitation, inelastic scattering with a preferred direction, a thermal bath.

This contrast becomes crisp by considering the implementation of the present disclosure shown in Fig. 21, which is drawn such as to be readily comparable to Fig. 1c of A.M. Bozkurt et al, Phys. Rev. B 97, 245414 (2018). This implementation makes use of a spatially distinct scattering area A. In this area, scattering centers are present that are characterized by a preferred down-spin to up-spins scattering. The preferred spin scattering direction is obtained by locally breaking the spatial symmetry by applying a magnetic field, for example by means of a permanent magnet. The scattering centers may consist, for example, of atoms that provide two empty states for electrons, one state for each spin direction, these states being Zeeman-split in energy by means of the locally applied magnet field. The unoccupied atoms do neither require a nuclear spin nor a total electron spin. These atoms are coupled to the thermal bath in which the device is embedded. To enhance the output signal, on may also apply a scattering area B to the bottom channel, which, however, is required to have different spin-flip properties than area A. In the example shown, area B has a preferred up-spin to down-spin scattering direction, which is achieved by applying a magnetic field that has the opposite polarity of the field of A.

As is obvious from the explanations provided, the preferential spin-flip scattering will cause a preferential direction of the electron travel in the upper channels, which results in a difference in the electrochemical potential of the two contacts.

In the following, examples for further embodiments or implementations of the present disclosure are presented.

(a) Devices according to the first aspect comprising further sample geometries, e.g., only interrupting the incompressible loop at one spot.

(b) Optimizing the sample geometry to have large areas that work as stripes to gain larger out signals. Implementations: 1) use of surface currents instead edge currents; (2) distribute incompressible channels across the surface area of the sample (compare Figs. 13, 14.)

(c) Contacts (5) to establish only contacts to next stripe element, not to the normal phase (3). One possible implementation: insulating film below at least part of the contact.

(d) Series and parallel connections of stripe elements according to wish.

(e) Stacking of the semiconductors to samples consisting of N layers, for example by using heterostructures, to amplify the output by N.

(f) Use of a multitude of gate electrodes to suppress the formation of a multitude of incompressible stripes.

(g) Use of impurity diffusion or defect formation to create normal phase for devices based on the quantum hall effect.

(h) Use of irradiation of the sample with particle beams or electromagnetic irradiation to create normal phase for devices based on the quantum hall effect.

(i) Examples f, g, h together with patterning process, as geometric structures.

(j) Use of inhomogeneous magnetic fields to create desired structures, e.g., desirably shaped stripes.

(k) Use of samples fabricated with inhomogeneous electronic or magnetic properties such as inhomogeneous carrier density, doping, dielectric susceptibility, magnetic susceptibility, electric polarization, magnetization, surface structures to create desired structures, e.g., desirably shaped stripes.

(l) Sample designs with suppressed shunt currents achieved by choosing the electric properties and the geometry of the sample.

(m) Using gate voltages to turn the effect on, off, or reverse its sign.

(n) Using light to turn the effect on, off, or reverse its sign.

(o) Materials of the quantum devices: Si, GaAs, other standard elemental semiconductors, III-V and II-VI semiconductors, ZnO, graphene, other 2-D materials, topological materials ($Bi_2Se_3$, Heusler and semi-Heusler alloys), semimetals, metals, materials comprising or consisting of organic molecules.

(p) Use of bulk single crystals, bulk polycrystals, bulk amorphous, films, heterostructures and multilayers.

(q) Replacing the tunnel contacts by other contacts such as Schottky contacts or ohmic contacts

(r) Fabricating the normal phase (3) such that it has a high resistivity, minimizes the shunt current

(s) Use permanent, nuclear spin polarization or electric magnets to generate the magnetic field.

(t) Use homogeneous electric fields and/or inhomogeneous magnetic fields which may be locally oriented in any direction.

(u) Use of an optimized operating temperature to achieve desired device behaviour, below room temperature, room temperature, and above room temperature.

The present disclosure is also directed to the use of a quantum device according to the first aspect or an array of two or more quantum devices according to the second aspect in an electrical device by connecting the two terminal of the quantum device or the two outer terminals of the array of quantum devices with a load of the electrical device.

The present disclosure is also directed to a method for converting thermal energy into one or more of electric voltages, currents, magnetic fields or inhomogeneities of temperatures or electron spin populations according to the third aspect, the method comprising

fabricating a quantum device according to the first aspect or an array of quantum devices according to the second aspect; and
connecting the quantum device to a load or other device configured to yield one or more of electric voltages, currents, magnetic fields or inhomogeneities of temperatures or electron spin populations.

According to an embodiment of the method according to the fourth aspect, in case of a quantum device functioning on the basis of the quantum hall effect, a further step of activating the quantum device comprises applying and/or altering a magnetic field to the transmission structure and adjusting the strength of the magnetic field such that an incompressible stripe is formed at the at least one first region.

While the present disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the present disclosure.

## Claims

1. A quantum device (10; 20; 30; 40; 50; 60), comprising

   - a transmission structure (1; 1a, 1b; 21; 31; 41; 51; 61) provided by a topological material (10A; 20A; 30A; 40A; 50A; 60A) and
   - at least two terminals (5; 8; 24; 34; 42, 43; 52, 53; 62, 63) connected with the transmission structure;

   wherein

   the transmission structure is functional to generate currents of electrons, holes or other quasiparticles between the at least two terminals; and wherein
   at least one or more of

   - a region (A, B) of the topological material (40A, 50A; 60A)),
   - one or both of the at least two terminals (5; 8), or
   - a further element or material (23; 33)

   are functional to inelastically scatter at least a part of the currents.

2. The quantum device (10; 20; 30; 40; 50; 60) according to claim 1, wherein at least one or more of

   - a region (A, B) of the topological material (40A; 50A; 60A)),
   - one or both of the at least two terminals (5; 8), or
   - a further element or material (23; 33)

   is connected to a thermal bath.

3. The quantum device (10; 20; 30; 40; 50; 60) according to claim 1 or 2, wherein
   the transmission structure (1; 1a, 1b; 21; 31; 41; 51; 61) is a non-reciprocal transmission structure (1; 1a, 1b; 21; 31).

4. The quantum device (10; 20; 30; 40; 50; 60) according to any one of the preceding claims, wherein
   the transmission structure (1; 1a, 1b; 21; 31; 41; 51; 61) is functional to generate the currents when the at least two terminals operate at one and the same temperature.

5. The quantum device (10; 20; 30; 40; 50; 60) according to any one of the preceding claims, wherein
   the transmission structure (1; 1a, 1b; 21; 31; 41; 51; 61) extracts heat energy from a surrounding heat bath and converts the heat energy into the generation of the currents.

6. The quantum device (10; 20; 30; 40; 50; 60) according to any one of the preceding claims, wherein
   the functional principle of the quantum device is based on either one of the quantum hall effect, the quantum spin hall effect, the quantum anomalous hall effect, or surface currents on a 3D topological material.

7. The quantum device (10) according to claim 6, wherein

   the functional principle of the quantum device is based on the quantum hall effect, wherein at least one first region (1) of the topological material (10A) is formed between the at least two terminals (5; 8) such that the at least one first region (1) is adapted to develop into an at least one incompressible stripe (1) upon application of a magnetic field of a predetermined strength, in which incompressible stripe (1) a current of electrons is generated in a unidirectional and dissipation free manner.

8. The quantum device (10) according to claim 7, wherein

   the at least one first region (1) is surrounded by an at least one second region (3), wherein the at least one first region (1) comprises a first mean free path of electrons, and the at least one second region (3) comprises a second mean free path of electrons, wherein the first mean free path is higher than the second mean free path.

9. The quantum device (10) according to claim 8, wherein
   the first mean free path is higher than the second mean free path by a factor of 10 or more.

10. The quantum device (10) according to any one of claims 7 to 9, wherein
    the first region (1) comprises a width greater than 50 nm.

11. The quantum device (30) according to any one of claims 7 to 10, further comprising
    at least one electrode (35) connected with the transmission structure (31) and configured to generate an electric field to induce the hall effect or to direct the electrons in a desired direction.

12. The quantum device (40, 50) according to claim 6, wherein the functional principle of the quantum device is based on the quantum spin hall effect, wherein in the transmission structure (41; 51) at least one first region of the topological material (40A; 50A) is adapted so that two chiral currents of electrons with opposite spin directions circle in opposite directions on paths which are connected with two opposing terminals (42, 43; 52, 53), in which first region at least two inelastic scattering centres (A, B) are arranged in the paths, which inelastic scattering centres provide spin-flip-scattering with different spin-scattering directions, resulting in a difference of the electrochemical potentials of the two terminals.

13. The quantum device according to claim 6, wherein

the functional principle of the quantum device is based on the anomalous quantum hall effect, wherein

in the transmission structure at least one first region of the topological material is adapted so that two chiral currents of electrons with opposite spin directions circle in opposite directions on paths which are connected with two opposing terminals, in which first region at least two inelastic scattering centres are arranged in the paths, which inelastic scattering centres provide spin-flip-scattering with different spin-flip-scattering directions and different spin-flip-scattering strengths, resulting in a difference of the electrochemical potentials of the two terminals and a magnetic field.

14. An array (100; 200) of two or more quantum devices according to any one of the preceding claims, wherein

the quantum devices are connected to each other in series and/or in parallel or antiparallel.

15. Use of a quantum device according to any one of claims 1 to 13 or an array of two or more quantum devices according to claim 14 in an electrical device by connecting the two terminals of the quantum device or the two outer terminals of the array of quantum devices with the electrical device.

16. A method for converting thermal energy into one or more of electric voltages, currents, magnetic fields or inhomogeneities of temperatures or electron spin populations, the method comprising

fabricating a quantum device according to any one of claims 1 to 13 or an array of quantum devices according to claim 14; and
connecting the quantum device to a load or other device configured to yield one or more of electric voltages, currents, magnetic fields or inhomogeneities of temperatures or electron spin populations.

Fig. 1

Fig. 2

Fig.3

Fig. 4

Fig. 5

incompressible stripe (1)

normal phase (3)

incompressible stripe (1)

$B_z$

a     b     c

$x$

$y$

Fig.6

Fig. 7

Fig. 8

gate electrode (4)

$V_g < 0$

$B_z$

$E_y$

a

incompressible stripe (1)

x  y

(a), left edge            (b), bulk            (c) right edge of sample

$E$

$\mu_c$

$\Delta\varphi_{e,\text{edge}}$

DOS

QHE, $\nu = 2$            compressible, ohmic            compressible, ohmic

Fig. 9

EP 4 318 928 A1

<u>10</u>

$\otimes$ $B_z$

contact (5)

tunnel barrier (6)

compressible stripes (2)

incompressible stripe (1)

<u>10A</u>

tunnel barrier (6)

contact (5)

normal phase (3)

x ↑
y →

Fig. 10

Fig. 11

normal phase (3)

$B_z$

slit (7)

incompressible stripe (1)

x

y

Fig.12

gate electrode (4a)

gate electrode (4b)

gate electrode (4a)

incompressible stripe (1)

sample area with
compressible electron fluid

$B_z$

Fig. 13

Fig.14

Fig. 15

incompressible stripe

electrodes to apply the electric field to induce the Hall effect

Fig. 16

EP 4 318 928 A1

Fig.17

EP 4 318 928 A1

Fig. 18

Fig. 19

Fig. 20

Fig. 21

**EP 4 318 928 A1**

Europäisches Patentamt
European Patent Office
Office européen des brevets

# EUROPEAN SEARCH REPORT

Application Number

EP 22 18 8376

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MANNHART JOCHEN ED - GENCER ALI ET AL: "Beyond Superconductivity", JOURNAL OF SUPERCONDUCTIVITY AND NOVEL MAGNETISM, SPRINGER US, BOSTON, vol. 33, no. 1, 12 September 2019 (2019-09-12), pages 249-251, XP037002566, ISSN: 1557-1939, DOI: 10.1007/S10948-019-05286-3 [retrieved on 2019-09-12] | 1-10,15, 16 | INV. H02N11/00 H10N15/00 |
| Y | * page 249, right-hand column, second paragraph * | 12-14 | |
| A | * page 250, left-hand column, last paragraph to right-hand column, first paragraph * * page 250, left-hand column, fifth and sixth paragraphs * * figure 1 * | 11 | |
| Y | MANNHART J ET AL: "Non-unitary Quantum Electronics: Novel Functions from the Edge of the Quantum World", ARXIV.ORG, CORNELL UNIVERSITY LIBRARY, 201 OLIN LIBRARY CORNELL UNIVERSITY ITHACA, NY 14853, 13 October 2020 (2020-10-13), XP081896208, DOI: 10.1088/2632-959X/ABEE06 * page 9, line 2 - line 3 * * figures 2,6 * | 14 | TECHNICAL FIELDS SEARCHED (IPC) H02N |
| Y | DIMITRIE CULCER ET AL: "Transport in two-dimensional topological materials: recent developments in experiment and theory", ARXIV.ORG, CORNELL UNIVERSITY LIBRARY, 201 OLIN LIBRARY CORNELL UNIVERSITY ITHACA, NY 14853, 23 July 2019 (2019-07-23), XP081447526, * page 2-3, "1. Introduction * | 12,13 | |

The present search report has been drawn up for all claims

| Place of search | Date of completion of the search | Examiner |
|---|---|---|
| Berlin | 13 February 2023 | Foussier, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

36

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2019052634 W
- EP 2019058649 W
- EP 2019074347 W
- EP 2020068812 W
- EP 21209862 A
- WO 2018027243 A1

### Non-patent literature cited in the description

- **J. MANNHART.** *Journal of Superconductivity and Novel Magnetism,* 2018, vol. 31, 1649
- **J. MANNHART ; D. BRAAK.** *Journal of Superconductivity and Novel Magnetism,* 2018, vol. 31, 1649
- **BREDOL et al.** *Phys. Rev. B.,* 2021, vol. 104, 115413
- **J. MANNHART et al.** *Physica E,* 2019, vol. 109, 198-200
- **J. MANNHART.** *Journal of Superconductivity and Novel Magnetism,* 2020, vol. 33, 249
- **J. MANNHART ; H. BOSCHKER ; P. BREDOL.** *Nano Express,* 2021, vol. 2, 014998
- **R.R. GERHARDTS.** *Phys. Stat. Sol. (B),* 2008, vol. 245, 378
- Quantum Hall Effect. **R.R. GERHARDTS et al.** Compendium of Quantum Physics. Springer, 2009, 572
- **K. PANOS et al.** *New J. Phys.,* 2014, vol. 16, 113071
- **K. V. KLITZING.** *Phil. Trans. R. Soc. A,* 2005, vol. 363, 2203
- **K. V. KLITZING et al.** *Phys. Journ.,* 2005, vol. 4, 37
- **K. V. KLITZING.** *Annu. Rev. Condens. Matter Phys.,* 2017, vol. 8, 13
- **J. WEIS et al.** *Phil. Trans. R. Soc. A,* 2011, vol. 369, 3954
- **S. OH.** *Science,* 2013, vol. 340, 153
- **Y. ANDO.** *J. Phys. Soc. Jpn.,* 2013, vol. 82, 102001
- **M. BÜTTIKER.** *Phys. Rev. B.,* 1988, vol. 38, 9375
- **C. KANE et al.** *Physics World,* February 2011, 32
- **A.M. BOZKURT et al.** *Phys. Rev. B,* 2018, vol. 97, 245414